# FASCICULE DE BREVET EUROPEEN

(11) **EP 2 135 987 B1**
(45) Date de publication et mention de la délivrance du brevet: **22.12.2010**
(21) Numéro de dépôt: 09290464.8
(22) Date de dépôt: 18.06.2009
(51) Int. Cl.: D06B 11/00, D06Q 1/04, D06M 11/83, D06M 15/19, D06M 23/16, H05K 3/00, H05K 3/12, C03C 25/10

(54) **Procédé de dépôt de capteurs sur un support poreux**
Verfahren für das Anbringen von Sensorverbindungen auf ein poröses Substrat
Process for the deposition of sensors on a porous substrate

(30) Priorité: 20.06.2008 FR 0803456
(43) Date de publication de la demande: 23.12.2009
(73) Titulaire: Commissariat à l'Énergie Atomique et aux Énergies Alternatives, 75015 Paris (FR)
(72) Inventeur: Revol Cavalier, Frédéric, 38180 Seyssins (FR); David, Nadine, 38140 La Murette (FR); Schoumacker, Sébastien, 38100 Grenoble (FR)
(74) Mandataire: Corizzi, Valérie

(56) Documents cités:
- EP-A- 1 291 463
- DE-A1-102005 062 028
- GASANA ET AL: "Electroconductive textile structures through electroless deposition of polypyrrole and copper at polyaramide surfaces" SURFACE AND COATINGS TECHNOLOGY, ELSEVIER, AMSTERDAM, NL, vol. 201, no. 6, 17 novembre 2006 (2006-11-17), pages 3547-3551, XP005729322 ISSN: 0257-8972
- DA COSTA M: "La métallisation des polymères" TECHNOLOGIES INTERNATIONALES,, no. 80, 1 janvier 2002 (2002-01-01), pages 25-28, XP009112068 ISSN: 1165-8568
- J. Rey-Debove & A. Rey: "Le Nouveau Petit Robert" 2000, Dictionnaires Le Robert , page 2322

## Description

L'invention a pour objet un nouveau procédé de dépôt de capteurs, tels que des métaux, des molécules biologiques, sur un support poreux suivant un motif choisi.

L'industrie du textile cherche à développer des tissus dits intelligents, qui permettent, outre les fonctions habituelles des textiles, d'apporter des fonctionnalités supplémentaires au tissu. Dans certains projets des déodorants ou des médicaments sont intégrés dans un tissu pour être diffusés dans le temps. Sur le marché des vêtements on trouve des vêtements techniques comportant des fonctionnalités nouvelles : Par exemple la société « MULLIEZ » propose des vêtements permettant de fixer les odeurs telles que l'odeur de friture ou de transpiration. D'autres vêtements de la même société contiennent des produits anti-moustiques, destinés notamment à prévenir le paludisme. D'autres sociétés comme « DIM »ou « TRIUMPH » proposent des collants amincissants ou hydratants à base de capsules dissimulées entre les fibres du collant.

D'autres développements concernent l'implantation d'éléments électroniques dans le vêtement pour par exemple faire un monitoring cardiaque. Le maintient à domicile le plus longtemps possible des personnes âgées favorise l'évolution de la mise au point des capteurs intégrés dans les vêtements pour suivre les paramètres physiologiques des personnes à surveiller. On peut également citer une radio FM connectée au vêtement. Les équipements de sécurité ou les combinaisons militaires sont équipées de plus en plus avec des capteurs mesurant l'environnement extérieur (pollution, radioactivité) mais également des données physiologiques de la personne portant le vêtement (rythme cardiaque, température, stress, positionnement GPS, ..). Les capteurs électriques ou électrochimiques permettent la mesure de différents paramètres physiologiques comme par exemple la mesure de la conductivité ionique de la sueur du patient qui peut donner une information sur sa déshydratation. La mesure de l'activité cérébrale peut être suivie par la mesure de l'activité électrique des neurones (électroencéphalogramme). La température peut être suivie par une mesure électrique. Le pH peut également être contrôlé par des mesures électrochimiques. On peut citer également le suivi de traitements médicaux actifs par la lecture de réponses biologiques via des capteurs spécifiques.

Tous ces capteurs nécessitent l'utilisation d'électrodes métalliques pour faire la mesure. L'approche actuelle consiste à développer des capteurs puis à les rapporter sur le vêtement par collage couture ou tissage. Le capteur n'est donc pas intégré dans le tissu, mais y est rapporté. Les capteurs sont élaborés de façon séparée puis ils sont cousus ou collés sur le vêtement et raccordés à l'électronique intégrée sur le vêtement par des fils électriques passés dans la doublure. Cette façon de faire représente une étape supplémentaire dans l'élaboration de l'article vestimentaire, et le plus souvent cette étape ne peut pas être automatisée. Elle représente donc un coût supplémentaire dans la fabrication de l'article. Une amélioration de ce procédé de fabrication consisterait à développer directement le capteur pendant la fabrication du tissu afin de pousser son intégration au maximum.

Pour cela, il faut pouvoir définir précisément des zones sur un tissu pour y déposer les matériaux ou les éléments que l'on veut intégrer au tissu. Notamment, il faut au préalable définir l'emplacement du capteur mais également sa forme et sa taille. Si l'on veut pouvoir comparer les données délivrées par différents capteurs il faut pouvoir déterminer la surface exacte du capteur qui va collecter une information. Si l'on veut délivrer un médicament il faut pouvoir connaître avec précision la surface d'échange entre le tissu contenant le médicament et la peau. La localisation des éléments intégrés dans le vêtement ainsi que la surface occupée par un capteur constituent des éléments primordiaux dans la maîtrise des mesures effectuées sur un vêtement.

Il faut donc être capable de délimiter des zones dans le tissu qui seront dédiées à la métallisation ou au greffage de capteurs chimiques ou biologiques par exemple.

On a également cherché à mettre au point un procédé qui simplifie globalement la fabrication des vêtements : dans le cas des vêtements comprenant des capteurs électroniques, par exemple, en créant simultanément le capteur et la remontée de contact, ce qui évite de devoir poser des connecteurs entre les capteurs et les fils électriques.

Jusqu'à présent, pour déposer des métaux sur un matériau poreux (tissu, papier, structure tissée) on a employé différentes méthodes : On peut tisser ou coudre des fils métalliques dans le matériau lors de sa fabrication. Cette technique est délicate car les métaux purs sont généralement ductiles et fragiles, et les techniques de fabrication des tissus ne sont pas toujours compatibles avec la mise en place de ces fils métalliques. Le coût des fils métalliques est élevé. Les surfaces réalisées sont en général de petite dimension (inférieure au cm²).

Un dépôt de métaux purs peut être effectué dans un pulvérisateur ou un évaporateur à travers un masque mécanique. Il faut que le tissu puisse être mis dans une machine à vide et le coût de cette opération est élevé. De plus ces techniques dites de dépôt physique (évaporation, pulvérisation) permettent de déposer du métal uniquement sur la surface du support. Ceci est un inconvénient majeur lors de l'utilisation du support (par exemple lavage ou frottement du tissu). Le dépôt risque d'être endommagé et la résistivité du capteur modifiée.

Une troisième technique consiste à utiliser une imprimante qui permet de déposer une encre métallique sur le tissu aux endroits choisis. Cette technique permet de réaliser des dépôts de métaux purs par voie chimique mais nécessite l'utilisation d'une imprimante. Ceci est envisageable si l'on n'a que quelques motifs à fabriquer mais dès lors que l'on veut imprimer plusieurs motifs distincts cette solution devient consommatrice de temps. De plus, l'encre conductrice ne s'étale pas de la même manière selon le type de tissu que l'on considère. L'hydrophilie du tissu dépendant des fibres tissées, l'encre va plus ou moins mouiller le tissu et les dimensions obtenues diffèrent d'un tissu à l'autre.

Pour la fabrication des circuits imprimés, un support est revêtu d'une couche de cuivre sur laquelle on dépose une couche de nickel et d'or par un procédé chimique ou électrochimique. Dans ce cas la couche métallique est déposée sur la surface du support et pas dans l'épaisseur du support. Cette technique est utilisée pour des supports non poreux sur lesquels les pistes en cuivre sont obtenues à partir d'une gravure chimique.

La fabrication de tissus définissant des surfaces ou des volumes pour la métallisation ou l'encapsulation de molécules chimiques ou biologiques peut être réalisée grâce au procédé de l'invention, au moyen d'une technique dérivée de la sérigraphie.

La sérigraphie est une technique couramment utilisée dans la fabrication de dessins sur différents supports (vêtement, papier). Cette technique permet l'impression de motifs sur un tissu. Un motif est dessiné sur une grille. Une encre colorée est déposée sur la surface supérieure de la grille puis raclée au travers du motif dessiné pour venir colorer le matériau positionné sous la grille. L'encre déposée recouvre la surface du tissu et rentre par capillarité sur une certaine profondeur dans les mailles du tissu. Le document WO2006/011168 décrit un procédé de fabrication de motifs à base de silicone sur la partie supérieure d'un bas afin de créer une zone permettant que le bas tienne sur la jambe sans autre moyen de fixation. Ce procédé fait appel à la technique de la sérigraphie

Un premier objet de l'invention est un procédé de fabrication d'un article comprenant un support poreux sensiblement plan et des zones définies dans ce support suivant un motif choisi, ces zones étant greffées par des capteurs choisies parmi : des molécules chimiques, des molécules biologiques, tandis que le reste du support reste libre de ce greffage.

On entend par capteur toute molécule qui peut permettre de réaliser un capteur chimique ou biologique. C'est-à-dire une molécule qui est capable d'interagir avec le milieu dans lequel le support poreux sur lequel elle est déposée va être introduit. Par exemple un capteur peut être :
- une molécule chimique de toute nature,
- un indicateur coloré qui par un changement de couleur signale un changement de pH,
- un brin d'ADN permettant une reconnaissance biologique,
- une protéine capable d'être reconnue par des enzymes,
- un ARN.

Parmi les molécules chimiques, on cite en particulier les molécules métalliques et les molécules organiques. Par molécule métallique, on entend essentiellement les molécules comprenant un ou plusieurs atomes métalliques, telles que notamment les métaux et leurs alliages, les sels et les dérivés de métaux comme les oxydes métalliques, les complexes de molécules métalliques avec des molécules organiques.

Ce procédé est **caractérisé en ce qu'**il comporte au moins les étapes suivantes :
(i) définition des zones de greffage sur le support poreux,
(ii) application sur au moins une face du support poreux, par sérigraphie, d'une résine liquide polymérisable sur la zone exclue du greffage,
(iii) polymérisation de la résine,
(iv) imprégnation du support poreux par une solution ou une dispersion de capteurs,
(v) fixation des capteurs sur le support,
(vi) éventuellement retrait de la résine, par exemple par dissolution.

Le support poreux peut être à base de tout type de fibre : fibres de textile naturelles ou synthétiques, comme par exemple coton, lin, polyester, polyamide, fibres acryliques ; fibres issue du traitement du bois comme par exemple fibres de cellulose, de viscose ; fibres minérales comme des fibres de verre. Le support poreux peut être à base d'un mélange de fibres. Il peut également résulter du mélange d'un ou plusieurs types de fibres et d'autres matières comme par exemple des polymères, notamment des élastomères, des polyéthers, des polyuréthanes, ou il peut comporter des charges. Il peut s'agir d'un matériau tissé, d'un non tissé, ou d'une mousse à cellules ouvertes. On peut prévoir que l'une des faces du support soit poreuse et l'autre non, comme par exemple un tissu fixé sur une couche de plastique, ou un silicium poreux déposé sur un silicium non poreux.

La définition des zones de greffage est liée à l'utilisation que l'on souhaite faire ultérieurement du support poreux greffé. Elle est laissée à la libre appréciation du concepteur du matériau. Elle peut être faite à l'aide de moyens automatisés (ordinateur, logiciel de dessin assisté par ordinateur) de façon à permettre un transfert des données directement vers l'appareillage de sérigraphie, notamment pour la création de la grille.

L'étape de sérigraphie est faite suivant une séquence d'opérations bien connue de l'homme du métier : la grille de sérigraphie définit, en les laissant libres, les zones où l'on souhaite déposer la résine, cette grille est placée sur le support poreux et celui-ci est imprégné par la résine liquide polymérisable.

Par pression, on force la résine à pénétrer dans le matériau poreux, par effet mécanique (pression) combiné à la capillarité, dans les espaces libres définis par le masque de sérigraphie. Cette résine peut ensuite être durcie, par exemple par exposition à l'air, par traitement thermique ou par traitement UV. Le masque de sérigraphie définit un motif de résine sur le support, ce motif étant constitué de deux types de zones :
- des zones A, imbibées de résine,
- des zones B, situées en regard du masque de sérigraphie, non affectées par l'application de résine, donc laissées libres.

L'application de la résine peut être réalisée sur toute l'épaisseur du support poreux, ou sur une épaisseur partielle. Elle peut également être réalisée successivement, de façon indépendante, suivant des motifs complémentaires ou indépendants, sur les deux faces du support. Le matériau sérigraphié peut l'être en une ou en plusieurs couches en fonction de sa viscosité et de la porosité du support.

La résine est choisie en fonction de sa thixotropie : une résine fortement thixotrope permet de contrôler plus facilement la pénétration de la résine dans l'épaisseur du support. Une forte thixotropie favorise également la définition et la précision du motif reporté sur le support. La nature du support et notamment sa porosité interviennent dans le choix de la résine.

Parmi les résines utilisables pour la mise en oeuvre de l'invention, on peut citer par exemple : les encres et vernis habituellement utilisés pour l'impression sur textile par sérigraphie, les résines thixotropes et polymérisables sous UV, telles les résines AZ4562 (Clariant), NFR15 (JSR micro), série 1800 (Shipplcy), les résines photosensibles utilisées en microélectronique ou les colles thixotropes, comme par exemple la colle Vitralit (Eleco), séries NBA, NEA ou NOA (Epotecny).

La polymérisation de la résine est contrôlée de façon à entraîner son durcissement et permettre la mise en oeuvre des étapes suivantes, notamment l'étape (iv) d'imprégnation du support poreux par une solution ou une dispersion de capteurs, sans que la résine ne se dissolve à cette occasion. Elle doit éventuellement encore pouvoir être retirée, par exemple par dissolution, à l'étape (vi) si l'on souhaite libérer les zones non fonctionnalisées du support.

L'imprégnation du support poreux par une solution ou une dispersion de capteurs, et la fixation des capteurs sur le support sont faits par différents moyens en fonction de la nature des capteurs.

Dans le cas où l'on souhaite fixer des molécules métalliques sur le support poreux, ces deux étapes peuvent être réalisées de la façon suivante :

Pour la métallisation du tissu, ce trempage peut inclure plusieurs bains successifs de solutions de Pd et Sn, puis de CuSO₄, puis des bains successifs des métaux choisis (Au, Ag, Pt...).

Différentes méthodes de métallisation d'un matériau poreux ont été décrites dans l'art antérieur. Une méthode est décrite dans Gasana E. et al., Surface and Coatings Technology, Vol.201, 6, 2006, 3547-3551 : dépôt de polypyrrole sur un support de polyaramide, activation par trempage dans une solution de SnCl₂-PdCl₂, puis activation par chemisorption de palladium ou de platine, trempage dans une solution de Cu (II), réduction en cuivre métallique.

Cette étape de métallisation peut également être réalisée selon la méthode décrite dans M. Da Costa, Technologies Internationales, 80, 2002, 25-28 : sur un support polymérique, traitement par de l'acide chromique, et de l'acide sulfurique, réduction des ions Cr(VI) par du glyoxal, de l'acide glyoxylique, de l'hydrazine, de l'hydroxylamine, de l'hydrosulfite de sodium, du bisulfite de sodium, du chlorure d'étain (II) ou un mélange de ces produits, activation par du chlorure d'étain et/ou du palladium, pré-immersion dans de l'acide chlorhydrique, imprégnation par le cuivre.

Selon un autre mode de réalisation, lorsque l'on souhaite fixer des molécules non métalliques sur le support poreux, les étapes (iv) et (v) sont des étapes de fonctionnalisation chimique ou biologique notamment de création de liaisons covalentes entre le support poreux et la molécule à greffer.

Par exemple, si le support comprend des fonctions SiO₂, sous forme d'une fibre de verre préalablement tissée ou intégrée dans une structure non-tissée ou une mousse, les étapes (iv) et (v) peuvent consister en une silanisation, le choix du silane dépendant de la fonction chimique ou biologique que l'on souhaite greffer par la suite. On peut également opérer une silanisation sur un tissu ou un non-tissé ou une mousse dans lesquels on a préalablement intégrées des microbilles de verre.

Cette silanisation permet ensuite de fixer des éléments biologiques ou chimiques compatibles avec les fonctions présentes sur le silane, tels des oligonucléotides ou des protéines.

Une silanisation peut être réalisée sur des supports autres que SiO₂, tels le nitrure de silicium, certains oxydes métalliques (ITO : oxyde d'Indium et d'Etain, Alumine), du silicium poreux, ou des matériaux composites à base de fibre de verre ou de silice.

Selon un troisième mode de réalisation, les étapes (iv) et (v) peuvent consister en un trempage dans une solution ou un dépôt d'une solution d'un indicateur coloré, adsorbé sur les fibres constituant le support. Cet indicateur coloré peut, par exemple, révéler la concentration d'une espèce biologique ou chimique (ion, molécule, protéine...) au-delà d'un seuil donné. Il peut d'agit d'un indicateur coloré dont la couleur dépend du pH, tel une solution aqueuse de Bleu de bromothymol, de Jaune de Méthyle, de Bleu de thymol, de Rouge de phénol, de Jaune d'alizarine ou de Méthylorange, ce qui permet de réaliser un capteur pH dans un tissu. Dans ce troisième mode de réalisation, l'indicateur coloré se fixe par adsorption sur les fibres du support poreux.

Le retrait de la résine peut être mécanique (grattage) ou, préférentiellement, peut consister en une dissolution de la résine dans un solvant (alcool, acétone, acétonitrile, chloroforme, toluène, eau chaude). Le choix du solvant dépend du type de la résine utilisée.

Les articles comprenant un support poreux fonctionnalisé par des capteurs, réalisés conformément au procédé de l'invention sont avantageusement destinés à être utilisés en présence d'un milieu liquide, et notamment un fluide corporel, les molécules capteurs réagissant en réponse à la détection d'une modification dans leur environnement.

Le procédé de l'invention permet ainsi de réaliser des piles électrochimiques.

Une telle pile intégrée directement dans le vêtement comporte au moins deux électrodes, chacune constituée d'un matériau conducteur différent et elle utilise comme électrolyte un fluide physiologique. En effet, la sueur, l'urine, les larmes ou le sang peuvent être utilisés comme liquide conducteur ionique pour faire fonctionner la pile.

### EXEMPLES

### A) Silanisation d'une fibre de verre

### 1) Sérigraphie résine

Sérigraphie de résine photosensible (Clariant) AZ4562 à travers un masque de sérigraphie.

Polymérisation aux UV (365 nm) pendant 2 mn.

### 2) Silanisation

Différents types de silane peuvent être utilisés, chacun ayant son propre protocole de fixation à la surface du matériau à fonctionnaliser. Le choix du silane à utiliser dépend de la fonction chimique que l'on veut utiliser soit directement soit pour la réalisation ultérieure d'une réaction chimique ou la fixation d'un élément biologique. Parmi les silanes les palus couramment utilisés on peut citer l'aminopropyltriéthoxysilane, l'aminopropyldiméthyléthoxysilane, le 5,6-époxyhéxyl triéthoxysilane, le 2-(hydroxyéthyl)-3-aminopropyl-triéthoxysilane.

Le protocole de silanisation utilisé pour l'aminopropyldiméthyléthoxysilane (pour celui-ci, pas besoin de recuit car pas de réticulation possible) est décrit ci-dessous :
- Support : fibre de verre.
- Application d'une résine par sérigraphie.
- Durcissement de la résine par insolation UV.
- Traitement par plasma d'oxygène (nextral 310) 150 Watt durant 30 s de façon à créer à la surface de la fibre de verre des fonctions silanols.
- Incubation dans une solution de silane à 1% (v/v) et de triéthylamine 3% (v/v) dans de l'heptane pendant 12h.
- Rinçage à l'heptane.
- Rinçages à l'eau distillée.

### B) Fixation d'un composé biologique (ADN) ou d'une fonction chimique

La technique de silanisation présentée ci-dessus au § A, permet de fixer des oligonucléotides, des protéines ou tout élément biologique ou chimique compatible avec les fonctions présentes sur le silane fixé aux matériaux fonctionnalisé (fonctions amine, acide aldéhyde, ester activé ...).

L'entité biologique peut être fixée directement sur le support par réaction avec les fonctions présentes sur le silane (exemple : réaction entre les amines primaires portées par les acides aminés lysines et une fonction ester activée présente sur le support) ou bien par l'intermédiaire d'un linker (ex : glutaraldéhyde)

### C) Capteur de pH sur tissu

Support : Tissu polyester 90%/élasthanne 10% (115g/m² ± 10%)

### 1) Sérigraphie résine

Sérigraphie de résine AZ4562 à travers un masque de sérigraphie définissant une zone dans laquelle le capteur de pH est intégré.

Polymérisation aux UV (365 nm) pendant 2 mn.

### 2) Fabrication du capteur de pH

Préparer une solution aqueuse de bromothymol avec 50 mg de bleu de bromothymol et 100 ml d'eau,

Déposer la solution aqueuse sur la zone définie par sérigraphie (2 x50µl),

Sécher à 65°C pendant 10 minutes,

Dissoudre la résine dans l'acétone pendant 1 à 2 minutes,

Sécher à la soufflette azote,

Test : dépôt d'une goutte de 5µl d'HCl 2M>>> coloration rose.

### D) Détermination d'une surface sur un matériau poreux :

### Figure 1

Une résine (1) est positionnée sur une grille de sérigraphie (2).Le support (3) est positionné sous la grille (2).

### Figure 2

Après étalement de la résine (1) au travers de la grille de sérigraphie (2), des zones avec résine (5) et sans résine (4) sont définies sur le support (3).

### Figure 3

Après retrait de la grille ; le support comporte des zones avec de la résine (5) délimitant des zones parfaitement définies sans résine (4).

### E) Détermination d'un volume sur un matériau poreux.

### Figure 4

Une résine (11) est positionnée sur une grille de sérigraphie (12). Le support (13) en matériau poreux est positionné sous la grille (12). Le volume de la résine (11) ou la taille de la grille (12) est calculé pour que la résine (11) ne pénètre dans le matériau poreux que sur une partie de l'épaisseur du support (13), et non sur la totalité.

### Figure 5

Après étalement de la résine (11) au travers de la grille de sérigraphie (12), des zones avec résine (15) et sans résine (14) sont définies sur le support (13).

### Figure 6

Une autre couche de résine est déposée par sérigraphie sur l'autre face du support (13) pour définir une autre zone de volume défini (16). Cette seconde couche de résine peut être composée de la même résine ou d'une résine différente de la première.

### F) Fonctionnalisation de la zone fabriquée.

### Figure 7

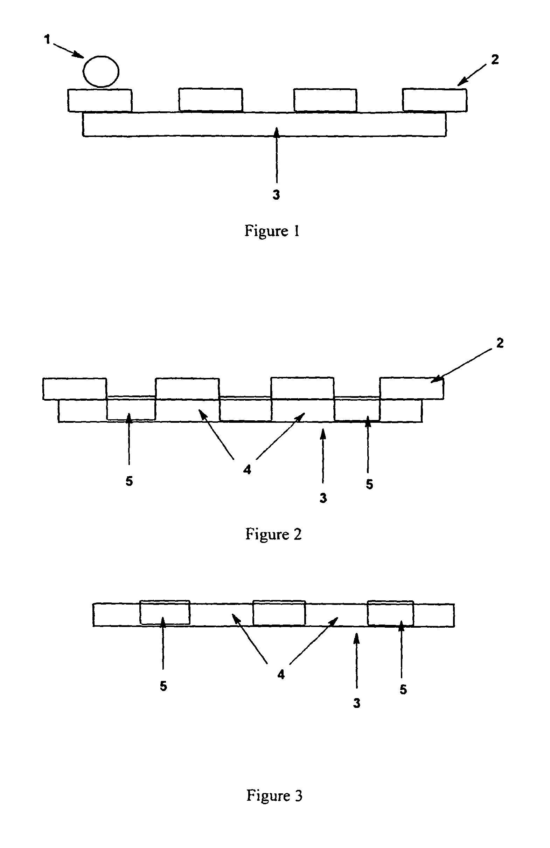

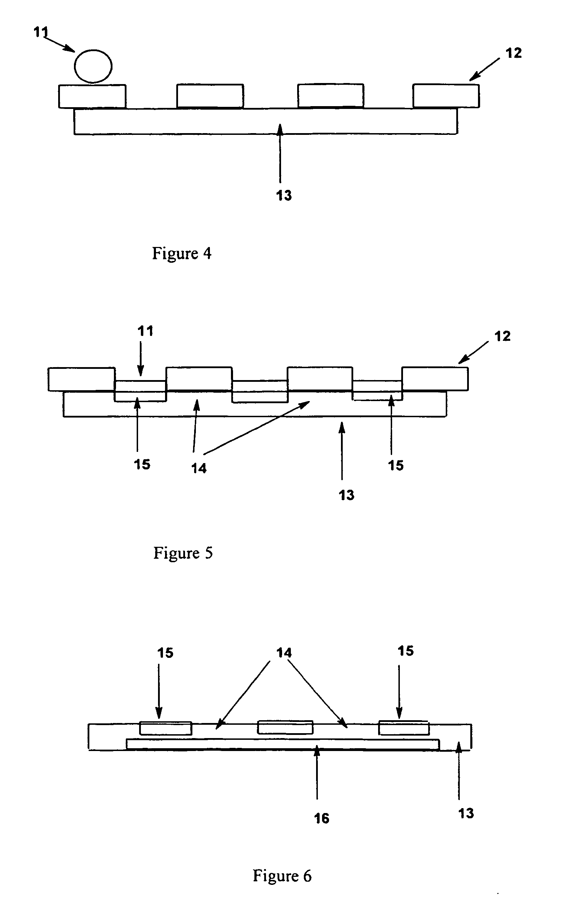

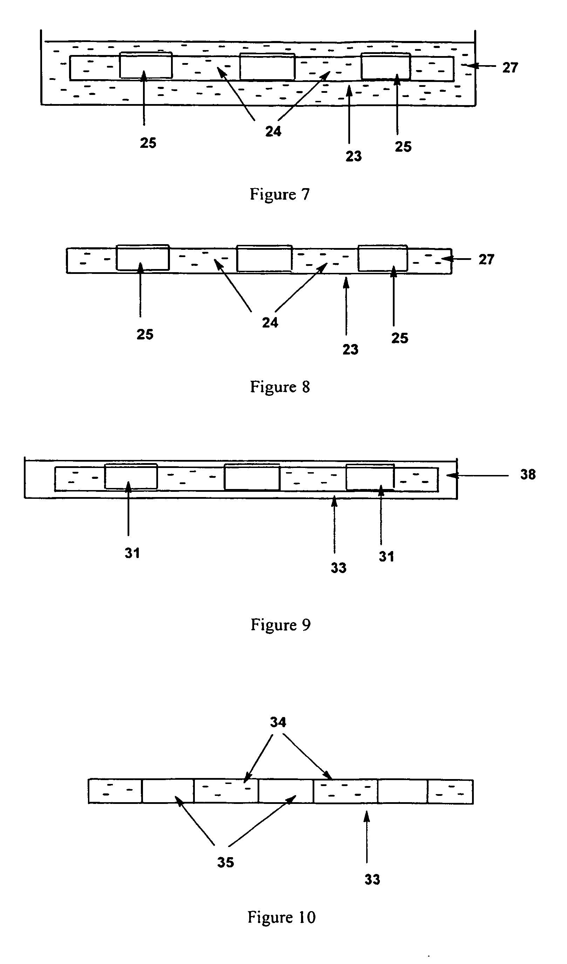

On utilise un support (23) identique à celui préparé au § D- figures 1 à 3. Un support (23) comprenant des zones imprégnées (25) de résine et des zones (24) libres de résine. Le support (23) est immergé dans un bain d'une solution (27) contenant les espèces chimiques ou biologiques à fixer sur le support (23).

La solution imprègne le support (23), et notamment pénètre dans les zones (24), libres de résine. Cette opération peut être répétée plusieurs fois avec des solutions de compositions différentes.

### Figure 8

Après fixation des espèces chimiques ou biologiques de la solution (27), le support (23) est retiré du récipient.

### G) Retrait de la colle ou résine.

Si nécessaire et pour que le support retrouve ses propriétés, il est possible de retirer la résine (32) du support (33).

### Figure 9

Le support (33) est immergé dans une solution (38) permettant de dissoudre la résine (31)

### Figure 10

Après dissolution de la résine (31), on obtient un support (33) comportant des zones (34) sur lesquelles se sont fixées les espèces chimiques et des zones (35) libres d'espèces chimiques et de résine.

### H) Réalisation de capteurs chimiques pour un contact avec la peau :

On réalise par le procédé décrit ci-dessus un dépôt de capteur chimique sur un textile ou autre support poreux destiné à être mis en contact avec la peau, ou un liquide corporel, en étant par exemple intégré à un pansement ou à un textile.

Il s'agit notamment d'un capteur de (Na+) dans la sueur. Cet exemple décrit l'utilisation de deux électrodes : une première électrode d'or et une seconde électrode en or sur laquelle un polymère conducteur a été déposé par voie électrochimique.

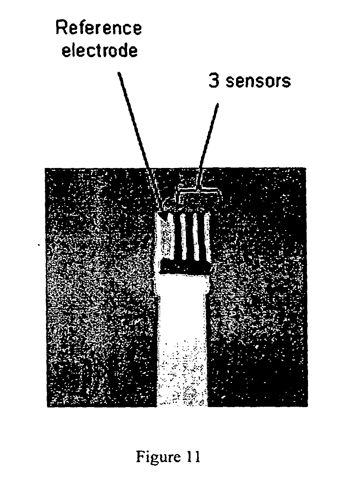

Les électrodes ont été connectées à un potentiostat Autolab par l'intermédiaire d'une feuille conductrice flexible et immergées dans une cellule électrochemique contenant une solution électrolytique, du pyrrole et du tetraéthylester d'acide tétraacétique 4-*tert-*butylcalix[4]arène. Le polymère polypyrrole a été déposé sélectivement par électrochimie sur trois électrodes définies en appliquant une tension de 1,2V pendant 30 secondes. A polymère noir a été obtenu comme on le voit sur la figure 11.

La photo de la figure 11 montre l'électrode de référence en Au et 3 électrodes sur lesquelles le polymère conducteur a été déposé.

On a ainsi un capteur électrochimique intégré au textile et au support poreux.

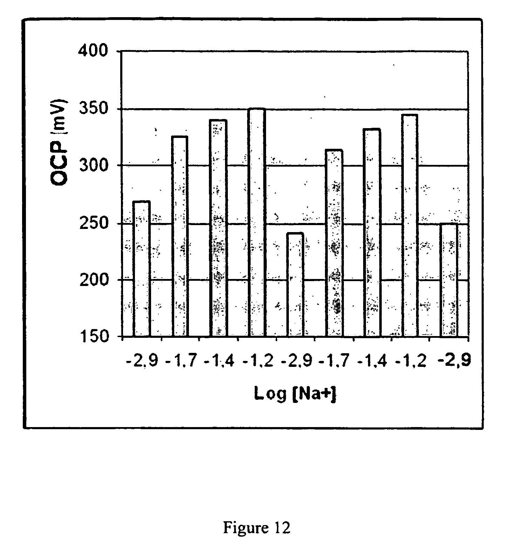

Ensuite, la capacité du capteur à détecter une variation de la concentration en Na⁺ a été évaluée en immergeant le tissu dans des solutions contenant des concentrations croissantes et décroissantes de Na⁺. A chaque concentration, le potentiel en circuit ouvert (OCP-open circuit potential) a été mesuré comme illustré sur la figure 12. Nous avons montré que l'OCP dépend des concentrations en ion sodium et ce potentiel suit parfaitement la variation de cette concentration. Par conséquent, on a obtenues une excellente réversibilité et une excellente reproductibilité

### I) Réalisation de piles électrochimiques

Pour la réalisation de piles électrochimiques, il est possible de déposer par électrolyse à l'aide du procédé de sérigraphie décrit ci-dessus différents métaux sur les électrodes dès lors qu'elles sont métallisées. Il faut alors tremper les électrodes dans une solution électrolytique comportant l'ion métallique à déposer et appliquer un potentiel électrochimique suffisant pour réduire l'ion métallique à la surface de l'électrode.

Les solutions suivantes peuvent être utilisées pour obtenir un dépôt métallique sur l'électrode en or :
- Solution de Siver cy less de Technic INC ® permet de déposer une couche d'argent sur l'electrode.
- Solution de Platinium AP de Technic INC ® permet de déposer une couche de Platine sur l'electrode
- Solution de sulfate de cuivre va permettre de déposer une couche de cuivre sur l'électrode par réduction électrochimique de l'ion cuivre.
- un dépôt de nickel chimique peut être obtenu également sur les électrodes avec une solution de chlorure de nickel ou de sulfate de nickel.

Ont peut alors envisager de déposer des électrodes de matériaux différents sur un tissu ou vêtement et ainsi réaliser des piles électrochimiques.

Une telle pile intégrée directement dans le vêtement comporte au moins deux électrodes, chacune constituée d'un matériau conducteur différent et elle utilise comme électrolyte un fluide physiologique. En effet, la sueur, l'urine, les larmes ou le sang peuvent être utilisés comme liquide conducteur ionique pour faire fonctionner la pile.

## Revendications

1. Procédé de fabrication d'un article comprenant un support poreux sensiblement plan et des zones définies dans ce support suivant un motif choisi, ces zones étant greffées par des capteurs, tandis que le reste du support reste libre de ce greffage, **caractérisé en ce qu'**il comporte au moins les étapes suivantes :
(i) définition des zones de greffage sur le support poreux,
(ii) application sur au moins une face du support poreux, par sérigraphie, d'une résine liquide polymérisable sur la zone exclue du greffage,
(iii) polymérisation de la résine,
(iv) imprégnation du support poreux par une solution ou une dispersion de capteurs,
(v) fixation des capteurs sur le support,
(vi) éventuellement retrait de la résine.

2. Procédé selon la revendication 1, dans lequel le support poreux est choisi parmi : un matériau tissé, un non tissé, une mousse à cellules ouvertes.

3. Procédé selon la revendication 1 ou la revendication 2, dans lequel la résine est choisie parmi : les encres et vernis habituellement utilisés pour l'impression sur textile par sérigraphie, les résines thixotropes et polymérisables sous UV, les résines photosensibles utilisées en microélectronique, les colles thixotropes.

4. Procédé selon l'une quelconque des revendications 1 à 3, dans lequel les capteurs sont choisis parmi: les métaux et leurs alliages, les sels et les dérivés de métaux comme les oxydes métalliques les complexes de molécules métalliques avec des molécules organiques.

5. Procédé selon la revendication 4 qui comporte des trempages dans plusieurs bains successifs de solutions de Pd et Sn, puis de CuSO₄, puis des bains successifs des molécules métalliques choisies, telles que notamment Au, Ag, Pt.

6. Procédé selon la revendication 4 qui comporte les étapes suivantes : dépôt de polypyrrole sur un support de polyaramide, activation par trempage dans une solution de SnCl₂-PdCl₂, puis activation par chemisorption de palladium ou de platine, trempage dans une solution de Cu (II), réduction en cuivre métallique.

7. Procédé selon la revendication 4 qui comporte les étapes suivantes : sur un support polymérique, traitement par de l'acide chromique, et de l'acide sulfurique, réduction des ions Cr(VI) par du glyoxal, de l'acide glyoxylique, de l'hydrazine, de l'hydroxylamine, de l'hydrosulfite de sodium, du bisulfite de sodium, du chlorure d'étain (II) ou un mélange de ces produits, activation par du chlorure d'étain et/ou du palladium, pré-immcrsion dans de l'acide chlorhydrique, imprégnation par le cuivre.

8. Procède selon l'une quelconque des revendications 1 à 3 qui comporte les étapes suivantes : sur un support qui comprend des fonctions SiO₂, les étapes (iv) et (v) consistent en une silanisation, puis fixation d'éléments biologiques ou chimiques compatibles avec les fonctions présentes sur le silane.

9. Procédé selon l'une quelconque des revendications 1 à 3 qui comporte les étapes suivantes : un trempage dans une solution ou un dépôt d'une solution d'un indicateur coloré.

10. Procédé selon l'une quelconque des revendications 1 à 9 qui comporte au moins une étape de dissolution de la résine.

## Claims

1. Process for the manufacture of an article comprising a substantially flat porous support and zones defined in that support according to a chosen pattern, the zones being grafted with sensors, while the remainder of the support remains free of that grafting, **characterised in that** it comprises at least the following steps:
(i) definition of the grafting zones on the porous support,
(ii) application on at least one face of the porous support, by means of screen printing, of a polymerisable liquid resin on the zone excluded from the grafting,
(iii) polymerisation of the resin,
(iv) impregnation of the porous support with a solution or dispersion of sensors,
(v) fixing of the sensors onto the support,
(vi) optionally removal of the resin.

2. Process according to claim 1, wherein the porous support is selected from: a woven material, a nonwoven, an open-cell foam.

3. Process according to claim 1 or claim 2, wherein the resin is selected from: inks and varnishes conventionally used for printing on textiles by screen printing, thixotropic and UV-polymerisable resins, photosensitive resins used in microelectronics, thixotropic adhesives.

4. Process according to any one of claims 1 to 3, wherein the sensors are selected from: metals and their alloys, salts and derivatives of metals, such as metallic oxides, complexes of metal molecules with organic molecules.

5. Process according to claim 4, which comprises immersion in several successive baths of solutions of Pd and Sn, then of CuSO₄, then successive baths of the chosen metal molecules, such as especially Au, Ag, Pt.

6. Process according to claim 4, which comprises the following steps: deposition of polypyrrole on a polyaramid support, activation by immersion in a SnCl₂-PdCl₂ solution, then activation by chemisorption of palladium or platinum, immersion in a Cu(II) solution, reduction to metallic copper.

7. Process according to claim 4, which comprises the following steps: on a polymeric support, treatment with chromic acid and sulfuric acid, reduction of the Cr(VI) ions by glyoxal, glyoxylic acid, hydrazine, hydroxylamine, sodium hydrosulfite, sodium bisulfite, tin(II) chloride or a mixture of those products, activation by tin chloride and/or palladium, pre-immersion in hydrochloric acid, impregnation with copper.

8. Process according to any one of claims 1 to 3, which comprises the following steps: on a support which comprises SiO₂ functional groups, steps (iv) and (v) consist in silanisation and then fixing of biological or chemical elements compatible with the functional groups present on the silane.

9. Process according to any one of claims 1 to 3, which comprises the following steps: immersion in a solution or deposition of a solution of a colour indicator.

10. Process according to any one of claims 1 to 9, which comprises at least one step of dissolution of the resin.

## Patentansprüche

1. Verfahren zur Herstellung eines Gegenstandes umfassend einen porösen in etwa ebenen Träger und bestimmte Bereiche auf diesem Träger, die einem ausgewählten Muster folgen, wobei diese Bereiche mit Sensormolekülen verpfropft sind, während der Rest des Trägers von diesen Verpfropfungen frei bleibt, **dadurch gekennzeichnet, dass** mindestens die folgenden Schritte umfasst sind:
(i) Definition der Pfropfbereiche auf dem porösen Träger,
(ii) Auftragung eines flüssigen polymerisierbaren Harzes auf mindestens eine Seite des porösen Trägers durch Siebdruck auf den Bereich, der von Verpfropfungen ausgeschlossen ist,
(iii) Polymerisation des Harzes,
(iv) Imprägnierung des porösen Trägers mit einer Lösung oder einer Dispersion aus Sensorverbindungen,
(v) Fixierung der Sensorverbindungen auf dem Träger,
(vi) gegebenenfalls Entfernung des Harzes.

2. Verfahren nach Anspruch 1, wobei der poröse Träger ausgewählt ist aus der Gruppe bestehend aus einem gewebten Material, einem Vlies, einem Schaumstoff mit offenen Poren.

3. Verfahren nach Anspruch 1 oder nach Anspruch 2, bei dem das Harz ausgewählt ist, aus den Folgenden: Tinten und Lacken, die gewöhnlich für den Druck auf Textilien mittels Tiefdruck verwendet werden, Thixotrope und durch UV-Licht polymerisierbare Harze, photoempfindliche Harze, die in der Mirkoelektronik verwendet werden, thixotrope Klebstoffe.

4. Verfahren nach einem der vorhergehenden Ansprüche 1 bis 3, bei dem die Sensorverbindungen ausgewählt sind aus den Folgenden: Metalle und deren Legierungen, Salze und Derivate von Metallen, wie Metalloxide, Komplexe aus metallischen Molekülen mit organischen Molekülen.

5. Verfahren nach Anspruch 4, das das Eintauchen in mehreren aufeinanderfolgenden Bädern umfasst, die Lösungen von Pd und Sn, dann CuSO₄ enthalten, dann in aufeinanderfolgenden Bädern von ausgewählten Metallmolekülen, wie insbesondere zum Beispiel Au, Ag, Pt.

6. Verfahren nach Anspruch 4, das die folgenden Schritte aufweist: Auftragen von Polypyrrol auf einem Träger aus Polyaramid, Aktivierung durch Eintauchen in einer Lösung aus SnCl₂-PdCl₂, danach Aktivierung durch Chemisorption von Palladium oder von Platin, danach Eintauchen in eine Lösung aus Cu(II), Reduktion in metallisches Kupfer.

7. Verfahren nach Anspruch 4, das die folgenden Schritte aufweist: auf einem polymeren Träger, Behandlung mit Chromsäure und Schwefelsäure, Reduktion von Cr(VI)-Ionen durch Glyoxal, Glyoxalsäure, Hydrazin, Hydroxylamin, Natriumhydrosulfit, Natriumbisulfit, Zinn(II)-chlorid oder einer Mischung aus diesen Produkten, Aktivierung durch Zinnchlorid und/oder Palladium, die Prä-Immersion in Salzsäure, Imprägnierung durch Kupfer.

8. Verfahren nach einem der vorhergehenden Ansprüche 1 bis 3, das die folgenden Schritte umfasst: auf einem Träger, der die Funktionen SiO₂ umfasst, bestehen die Schritte (iv) und (v) aus einer Silanisierung dann der Fixierung eines biologischen oder chemischen Bestandteils, der mit den Funktionen verträglich ist, die auf dem Silan vorhanden sind.

9. Verfahren nach einem der vorhergehenden Ansprüche 1 bis 3, das die folgenden Schritte aufweist: Eintauchen in eine Lösung oder Auftragen einer Lösung eines Farbindikators.

10. Verfahren nach einem der vorhergehenden Ansprüche 1 bis 9, das mindestens einen Schritt des Auflösens des Harzes umfasst.
